# EUROPEAN PATENT APPLICATION

(11) **EP 1 650 791 A1**
(43) Date of publication of application: **26.04.2006**
(21) Application number: 04747516.5
(22) Date of filing: 14.07.2004
(51) Int. Cl.: H01L 21/68, H01L 21/304

(54) **LAMINATING METHOD AND LAMINATING DEVICE**

(30) Priority: 29.07.2003 JP 2003281703
(71) Applicant: TOKYO ELECTRON LIMITED, Minato-ku, Tokyo 107-8481 (JP)
(72) Inventor: ARUGA, Tsuyoshi c/o Tokyo Electron AT Limited, Nirasaki-shi, Yamanashi 4078511 (JP); HAGIHARA, Junichi c/o Tokyo Electron AT Limited, Nirasaki-shi, Yamanashi 4078511 (JP); OKASE, Wataru c/o Tokyo Electron AT Limited, Nirasaki-shi, Yamanashi 4078511 (JP); YAMAGUCHI, Eiji c/o Tokyo Electron AT Limited, Nirasaki-shi, Yamanashi 4078511 (JP)
(74) Representative: Liesegang, Eva
(86) International application number: PCT/JP2004/010050
(87) International publication number: WO 2005/010979

(57) **Abstract**

A pasting method and a pasting apparatus hold a thin plate 1 and a planar member 2 in high flatness respectively on a first holding member 44 and a second holding member 44, a main controller 40a controls a moving mechanism 45 and a parallelism adjusting mechanism 52 on the basis of information provided by position recognizing mechanisms 33 and 34 to align the thin plate 1 and the carrying member 2 with each other in a predetermined positional relation. The main controller 40a controls a moving mechanism 45 so as to move the thin plate 1 and the carrying member 2 relative to each other in a state where a liquid-phase liquid crystal wax heated by a heater 49 is held between the thin plate 1 and the carrying member 2 to spread the liquid-phase liquid crystal wax over the entire surfaces of the thin plate 1 and the carrying member 2. Thus the thin plate 1, such as a semiconductor wafer or a metal foil, can be accurately, surely and efficiently pasted to the carrying member 2, and the thin plate 1 pasted to the carrying member 2 can be readily separated from the carrying member 2.

## Description

### TECHNICAL FIELD

The present invention relates to a pasting method of pasting a thin, flat object, such as a semiconductor wafer or a metal foil, to another object, and a pasting apparatus for carrying out the pasting method.

### BACKGROUND ART

Warping and cracking of semiconductor wafers (hereinafter, referred to simply as "wafers") have become an unignorable problem with the progressive increase in size of wafers and the progressive decrease in thickness of wafers in semiconductor device fabricating processes. If a wafer held by an electrostatic chuck warps, for example, during a wafer carrying process, a chemical-mechanical polishing process (COM process), a dry etching process or an ion-implantation process, the wafer cannot be accurately processed or is liable to crack.

To avoid such a trouble, a previously proposed technique subjects a wafer pasted to a backing substrate with an adhesive, such as wax, to a polishing process or the like. For example, a technique disclosed in JP 8-139165 A pastes a wafer to a backing substrate by a stamper and a technique disclosed in JP 10-12578 A uses a gage block for pasting a wafer to a backing substrate.

When wax is used for pasting a wafer to a backing substrate, it takes a comparatively long time for the liquid-phase liquid crystal wax to solidify into the solid-phase wax. Thus, processes for pasting the wafer to the backing substrate and for separating the wafer from the backing substrate need a long time. The wafer is liable to be displaced before the wax solidifies because the wax takes a long time to solidify. It is difficult to spread the wax not containing bubbles in a uniform thickness over a surface of the wafer and to paste the wafer accurately in a satisfactory flatness to the backing substrate by using only the stamper or the gage block.

Multilayer packaging technique that enables high-density packaging has been developed in the field of semiconductor device packaging to cope with increase in information capacity. The multilayer packaging technique uses an interposer (converter) of a size substantially equal to that of a silicon chip to reduce wiring area and connects electrodes on the lower surface of the silicon chip to the signal electrodes of the interposer. The interposer including a piece of very thin copper film of a thickness between 30 and 100 µm and a substrate needs to be pasted to a backing substrate for handling. When the technique disclosed in JP 8-139165 A or JP 10-12578 A is used in combination with the multilayer packaging technique, a problem arises in processing time and accuracy and it is difficult for those previously proposed techniques to paste a foil having a thickness not greater than 100 µm to the backing substrate.

The present invention has been made in view of the foregoing circumstances and it is therefore an object of the present invention to provide a pasting method and a pasting apparatus capable of accurately, surely and efficiently pasting a thin, flat object, such as a semiconductor wafer or a metal foil to another object, such as a carrying member, so as to be efficiently separable from the carrying member.

### DISCLOSURE OF THE INVENTION

A pasting method of pasting a thin plate to a member according to a first aspect of the present invention includes the steps of: holding the thin plate and the member vertically opposite to each other with their joining surfaces extended in high flatness respectively on first and second holding members capable of moving in directions along an X-axis, a Y-axis and a Z-axis and of turning in a θ-direction relative to each other; pouring a liquid crystal wax onto the thin plate when the thin plate is disposed below the member or onto the member when the member is disposed below the thin plate; heating the liquid crystal wax to keep the liquid crystal wax in a liquid phase; spreading the liquid-phase liquid crystal wax in a liquid-phase liquid crystal wax layer over the surfaces of the thin plate and the member by holding the liquid-phase liquid crystal wax layer between the thin plate and the member and moving the thin plate and the member relative to each other; adjusting the thickness of the liquid-phase liquid crystal wax layer to a predetermined thickness; and cooling the liquid-phase liquid crystal wax layer to solidify the liquid crystal wax layer.

A pasting method of pasting a thin plate to a member according to a second aspect of the present invention includes the steps of: holding the thin plate and the member vertically opposite to each other with their joining surfaces extended in high flatness respectively on first and second holding members capable of moving in directions along an X-axis, a Y-axis and a Z-axis and of turning in a θ-direction relative to each other; pouring a liquid crystal wax onto the thin plate when the thin plate is disposed below the member or onto the member when the member is disposed below the thin plate; aligning the thin plate and the member with each other on the basis of respective recognized positions of the thin plate and the member and; heating the liquid crystal wax to keep the liquid crystal wax in a liquid phase; completely spreading the liquid-phase liquid crystal wax in a liquid-phase liquid crystal wax layer over the surfaces of the thin plate and the member by holding the liquid-phase liquid crystal wax layer between the thin plate and the member and moving the thin plate and the member relative to each other; adjusting the thickness of the liquid-phase liquid crystal wax layer to a predetermined thickness; and cooling the liquid-phase liquid crystal wax layer to solidify the liquid crystal wax layer.

A pasting apparatus for pasting a thin plate to a member according to a third aspect of the present invention includes: first and second holding members respectively for holding the thin plate and the member opposite to each other so that respective joining surfaces of the thin plate and the member face each other; first and second holding mechanisms respectively for operating the first and the second holding member to hold the thin plate and the member flat respectively on the first and the second holding member; a moving mechanism for moving the first and the second holding member relative to each other in directions along an X-axis, a Y-axis and a Z-axis and turning the same in a θ-direction; a liquid crystal wax pouring mechanism for pouring a liquid crystal wax onto the thin plate when the thin plate is disposed below the member or onto the member when the member is disposed below the thin plate; heating means incorporated into at least either of the first and the second holding member; cooling means incorporated into at least either of the first and the second holding member; and a control mechanism for spreading the liquid crystal wax liquefied by the heating means in a liquid-phase liquid crystal wax layer over the joining surfaces of the thin plate and the member by holding the liquid-phase liquid crystal wax layer between the thin plate and the member and moving the thin plate and the member relative to each other.

A pasting apparatus for pasting a thin plate to a member according to a fourth aspect of the present invention includes:
first and second holding members respectively for holding the thin plate and the member opposite to each other with the respective joining surfaces of thereof facing each other; first and second holding mechanisms respectively for making the first and the second holding member hold the thin plate and the member flat, respectively; a moving mechanism for moving the first and the second holding member relative to each other in directions along an X-axis, a Y-axis, a Z-axis and turning the same in a θ-direction; a position recognizing mechanism for recognizing the respective positions of the thin plate and the member; a parallelism adjusting mechanism for adjusting parallelism between the thin plate and the member;
a liquid crystal wax pouring mechanism for pouring a liquid crystal wax onto the thin plate when the thin plate is disposed below the member or onto the member when the member is disposed below the thin plate; heating means incorporated into at least either of the first and the second holding member;
cooling means incorporated into at least either of the first and the second holding member; and a control mechanism for controlling the parallelism adjusting mechanism and the moving mechanism; wherein the control mechanism controls the parallelism adjusting mechanism and the moving mechanism on the basis of information provided by the position recognizing mechanism to position the thin plate and the member in a predetermined positional relation, and controls the moving mechanism in a state where the liquid crystal wax is held between the thin plate and the member to move the thin plate and the member relative to each other to spread the liquid crystal wax in a liquid crystal wax layer over the surfaces of the thin plate and the member.

A pasting method of pasting together two thin metal plates according to a fifth aspect of the present invention includes the steps of: individually and continuously supplying the two thin metal plates; guiding the two thin metal plates downward with the two thin metal plates spaced from each other by a space of a predetermined thickness; pouring down a liquid crystal wax into the space between the two thin metal plates; pressing the two thin metal plates holding the liquid crystal wax and moving downward to paste the two thin metal plates together; solidifying the liquid crystal wax by cooling the liquid crystal wax held between the two thin metal plates after the two thin metal plates have been pasted together in a laminated structure; and cutting the laminated structure.

A pasting apparatus for pasting together two thin metal plates according to a sixth aspect of the present invention includes: two supply rolls for individually and continuously supplying the two thin metal plates; guide rollers for guiding the two thin metal plates downward with the two thin metal plates spaced from each other by a space of a predetermined thickness; a liquid-phase liquid crystal wax pouring mechanism for pouring down a liquid-phase liquid crystal wax into the space between the two thin metal plates; pressure rollers for pressing the two thin metal plates to paste together the two thin metal plates holding the liquid crystal wax and moving downward; heating means for heating the two thin metal plates being pressed between the pressure rollers; cooling means for cooling the liquid crystal wax held between the two thin metal plates after the two thin metal plates have been pasted together in a laminated structure to solidify the liquid crystal wax; and cutting means for cutting the laminated structure.

The present invention uses the liquid crystal wax for pasting together the thin plate and the member. The liquid crystal wax changes its phase between a liquid phase and a solid phase at a predetermined temperature. Therefore, the thin plate can be pasted to the member and can be separated from the member in a very short time and hence the thin plate is not displaced easily.

According to the first to the fourth aspect of the present invention, the thin plate and the member are held vertically opposite to each other with their joining surfaces extended in high flatness so as to be moved in directions along an X-axis, a Y-axis and a Z-axis and to be turned in a θ-direction relative to each other. Therefore, the joining surfaces extended in satisfactory flatness can be accurately joined together. Since the liquid-phase liquid crystal wax held between the thin plate and the member is spread in a liquid-phase liquid crystal wax layer over the surfaces of the thin plate and the member by moving the thin plate and the member relative to each other, the liquid-phase liquid crystal wax layer will not contain bubbles and the thin plate and the member can be surely pasted together with the liquid crystal wax layer of a uniform thickness.

According to the second and the fourth aspect of the present invention, the respective positions of the thin plate and the member are recognized and the thin plate and the member are aligned with each other on the basis of the information about the positions of the thin plate and the member. Thus the thin plate and the member can be further accurately pasted together. More concretely, the thin plate and the member can be very accurately pasted together by positioning the thin plate and the member in a plane and adjusting the parallelism between the thin plate and the member.

According to the fifth and the sixth aspect of the present invention, the two thin metal plates are supplied individually and continuously, the two thin metal plates are guided for downward movement with the two thin metal plates spaced from each other by a space of a predetermined thickness, the liquid crystal was is poured into the space between the two thin metal plates, and the two thin metal plates holding the liquid crystal wax and moving downward are pressed to paste the two thin metal plates together. Thus the two thin metal plates can be surely and accurately pasted together without developing any bubbles in the liquid crystal wax.

### BRIEF DESCRIPTION OF THE DRAWINGS

Fig. 1 is a typical plan view of a pasting system including a pasting apparatus in a first embodiment according to the present invention;
Fig. 2 is a sectional view of the pasting apparatus in the first embodiment;
Fig. 3 is a flow chart of a pasting procedure to be carried out by the pasting apparatus shown in Fig. 2;
Figs. 4a to 4D are views of assistance in explaining operations for spreading a liquid crystal wax between a thin plate and a carrying member;
Fig. 5 is a sectional view of assistance in explaining a method of adjusting the thickness of a liquid crystal wax layer by particles contained in a liquid crystal wax;
Fig. 6 is a sectional view of assistance in explaining a method of adjusting the thickness of a liquid crystal wax layer by a thin plate provided with a three-dimensional pattern;
Fig. 7 is a sectional view of assistance in explaining tensioning a thin plate;
Fig. 8 is a view of assistance in explaining another method of pouring a liquid crystal wax onto the carrying member;
Fig. 9 is a sectional view of a pasting apparatus in a second embodiment according to the present invention; and
Fig. 10 is a sectional view in a horizontal plane of a metal foil and a metal carrying member holding a liquid crystal wax therebetween being moved downward.

### BEST MODE FOR CARRYING OUT THE INVENTION

Preferred embodiments of the present invention will be described with reference to the accompanying drawings.

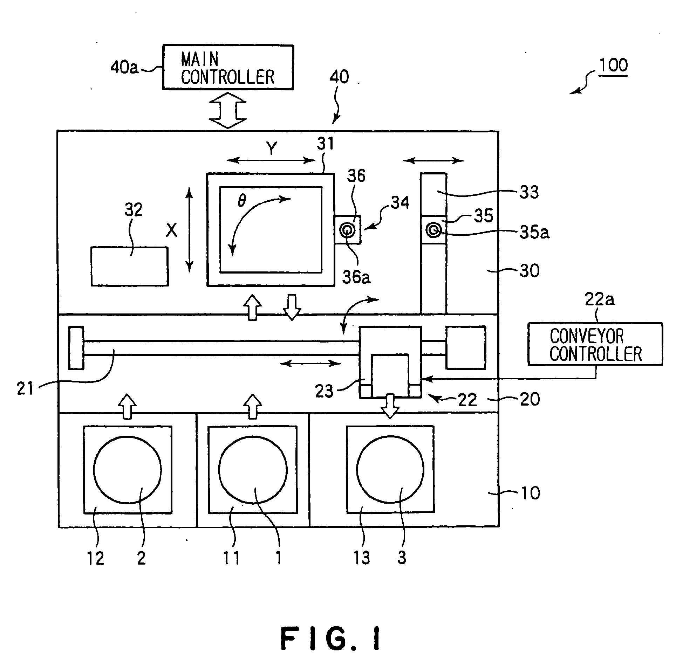

Referring to Fig. 1 showing a pasting system 100, the pasting system 100 includes a loading and unloading unit 10, a carrying unit 20 and a pasting unit 30. The loading and unloading unit 10 carries a thin plate 1 and a carrying member 2 for carrying the thin plate 1 into the pasting unit 30. The carrying unit 20 is interposed between the loading and unloading unit 10 and the pasting unit 30. The pasting unit 30 pastes the thin plate 1 and the carrying member 2 together.

The pasting unit 30 is provided with a pasting apparatus 40 in a first embodiment according to the present invention. The pasting apparatus 40 includes a main unit 31 disposed in a central part thereof, and a liquid crystal wax pouring mechanism 32 disposed beside the main unit 31. The liquid crystal wax pouring mechanism 32 pours a liquid crystal wax onto the carrying member 2 being carried. The pasting apparatus 40 has an upper position recognizing mechanism 33 and a lower position recognizing mechanism 34. A main controller 40a controls the pasting apparatus 40.

The loading and unloading unit 10 is provided with a thin plate cassette 11 for holding thin plates 1 therein, a carrying member cassette 12 for holding carrying members 2, and an end product cassette 13 for holding end products 3 each formed by pasting the thin plate 1 and the carrying member 2 together. The thin plate 1 is, for example, a silicon wafer or a metal foil, such as a copper foil.

The carrying unit 20 has a carrying robot 22 that moves along a carrying path 21 extended along the arrangement of the thin plate cassette 11, the carrying member cassette 12 and the end product cassette 13. The carrying robot 22 has a stretchable robot arm 23. The robot arm 23 can be turned between a position facing the loading an unloading unit 10 and a position facing the pasting unit 30. The robot arm 23 performs operations for taking out the thin plate 1 from the thin plate cassette 11, loading the thin plate 1 into the pasting apparatus 40, taking out the carrying member 2 from the carrying member cassette 12, loading the carrying member 2 into the pasting apparatus 40, taking out the end product formed by pasting together the thin plate 1 and the carrying member 2 from the pasting apparatus 40 and putting the end product into the end product cassette 13.

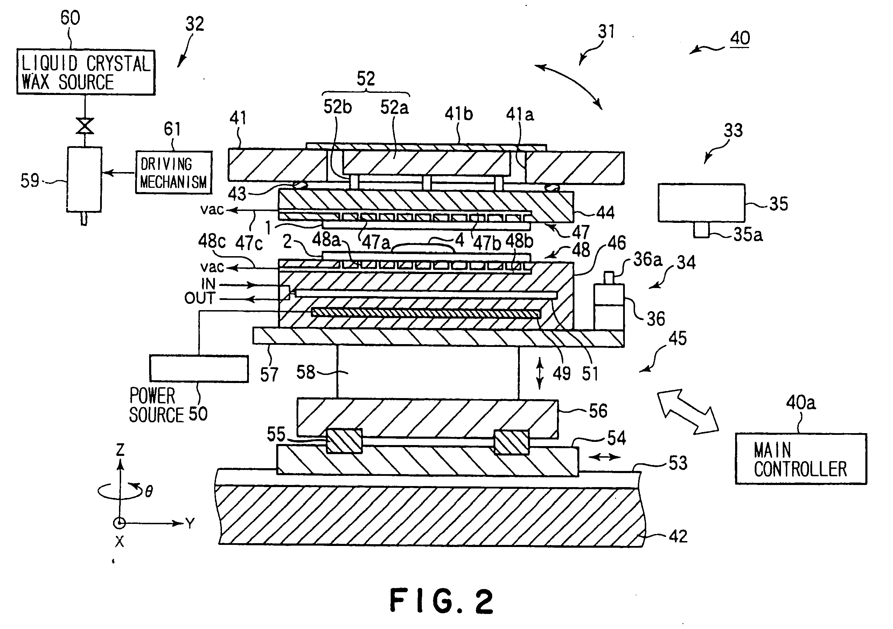

Referring to Figs. 2 showing the pasting apparatus 40 in a sectional view, the main unit 31 of the pasting apparatus 40 has a precision aligning mechanism similar to the aligning mechanism of a wafer prober for inspecting a semiconductor wafer. As shown in Fig. 2 the main unit 31 has a head plate 41 and a base plate 42. The head plate 41 and the base plate 42 are disposed parallel to each other in a predetermined positional relation and are fixed to an upper part and a lower part, respectively, of a body frame, not shown. The head plate 41 can be turned in the directions of the arrows.

A plate-shaped first holding member 44 for holding the thin plate 1 on its lower surface is supported movably by a floating mechanism 43 under the lower surface of the head plate 41. A plate-shaped second holding member 46 for holding the carrying member 2 on its upper surface is disposed opposite to the first holding member 44 and is supported on the base plate 42 by an XYZθ moving mechanism 45. The XYZθ moving mechanism 45 can move the second holding member 46 in directions along an X-axis, a Y-axis and a Z-axis and can turn the second holding member 46 in a θ-direction. The respective joining surfaces of the thin plate 1 held by the first holding member 44 and the carrying member 2 held by the second holding member 46 face each other. The suction surfaces of the first holding member 44 and the second holding member 46 are made of a heat-resisting glass to enable a liquid crystal wax to spread smoothly. The X- and the Y-direction are contained in a horizontal plane, the Z-direction is perpendicular to the horizontal plane, and the θ-direction is a turning direction about a vertical axis perpendicular to the horizontal plane.

The first holding member 44 is provided with a suction mechanism 47, namely, a first holding mechanism, for holding the thin plate. The suction mechanism 47 includes a plurality of suction grooves 47a formed in the lower surface of the first holding member 44, a suction passage 47b horizontally extended in the first holding member 44 and connected to the suction grooves 47a, and a suction line 47c connected to the suction passage 47b. A vacuum pump, not shown, is connected to the suction line 47c to attract the thin plate 1 to the lower surface of the first holding member 44 by suction. Thus the thin plate 1 can be held in high flatness on the lower surface of the first holding member 44. The thin plate 1 is liable to warp when the thin plate 1 has a very small thickness of 100 µm or below. The thin plate 1 can be attracted to and held on the lower surface of the first holding member 44 in high flatness even if the thin plate 1 is very thin by properly designing the suction grooves 47a.

The second holding member 46 is provided with a suction mechanism 48, namely, a second holding mechanism, for holding the carrying member 2. The suction mechanism 48 includes a plurality of suction grooves 48a formed in the upper surface of the second holding member 46, a suction passage 48b horizontally extended in the second holding member 46 and connected to the suction grooves 48a, and a suction line 48c connected to the suction passage 48b. A vacuum pump, not shown, is connected to the suction line 48c to attract the carrying member 2 to the upper surface of the second holding member 46 by suction. Thus the carrying member 2 can be held in high flatness on the upper surface of the second holding member 46.

A heater 49, namely, a heating means, is embedded in the second holding member 46. The heater 49 generates heat when a power source 50 supplies power to the heater 49. A coolant passage 51, namely, a cooling means, is formed in the second holding member 46. A cooling medium, such as cooling water, is passed through the coolant passage 51 to cool the carrying member 2 held on the upper surface of the second holding member 46. The carrying member 2 held on the upper surface of the second holding member 46 is heated by energizing the heater 49 to heat the carrying member 2 so that a liquid crystal wax, namely, an adhesive, spread over the carrying member 2 may be kept in a liquid phase. When the cooling medium is passed through the coolant passage 51, the liquid crystal wax spread on the carrying member 2 solidifies.

The head plate 41 is provided with a piezoelectric mechanism 52, namely, a parallelism adjusting mechanism, for adjusting parallelism between the joining surfaces of the thin plate 1 and the carrying member 2. The piezoelectric mechanism 52 is placed in a space 41a formed in a central part of the head plate 41 and is held fixedly on the head plate 41 by a fixing plate 41b. The piezoelectric mechanism 52 includes a support member 52a fixed to the fixing plate 41b, and a plurality of piezoelectric elements 52b supported on the lower surface of the support member 52a. The lower ends of the piezoelectric elements 52b are attached to the upper surface of the first holding member 44. When a predetermined voltage is applied to each of the piezoelectric elements 52b, the piezoelectric element 52a undergoes a dimensional change corresponding to the voltage applied thereto. The parallelism between the joining surfaces of the thin plate 1 and the carrying member 2 is adjusted by thus changing the dimensions of the piezoelectric elements 52a.

The XYZθ moving mechanism 45 includes a guide rail 53 extended parallel to the Y-axis on the upper surface of the base plate 42, a Y-table that moves along the guide rail 53 in directions parallel to the Y-axis, a guide rail 55 extended parallel to the X-axis on the upper surface of the Y-table, an X-table 56 that moves along the guide rail 55 in directions parallel to the X-axis, a support member 57 supporting the second holding member 46, and a Zθ member 58 connecting the X-table 56 and the support member 57 and capable of moving the support member 47 in directions parallel to the Z-axis and of turning the support member 47 in the θ-direction. A Y-direction driving mechanism, an X-direction driving mechanism, a Z-direction driving mechanism and a θ-direction driving mechanism, which are not shown, drive the Y-table 54 for movement parallel to the Y-axis, the X-table 56 for movement parallel to the X-axis and the Zθ member 58 for movement parallel to the Z-axis and for turning in the θ-direction. The XYZθ moving mechanism 45 moves the holding member 46 in directions parallel to the X-, Y- and Z-axis and turns the holding member 46 in the θ-direction. Thus the positional relation between the thin plate 1 and the carrying member 2 can be accurately adjusted.

The main controller 40a controls the piezoelectric mechanism 52 and the XYZθ moving mechanism 45 to achieve the accurate adjustment of the positional relation between the thin plate 1 and the carrying member 2 and to control the movement of the second holding member 46 when the thin plate 1 and the carrying member 2 are pasted together with the liquid crystal wax.

A lower position recognizing mechanism 34 is disposed beside the second holding member 46 supported on the support member 57. The lower position recognizing mechanism 34 takes an image of the thin plate 1 to obtain position information about the position of the thin plate 1. The lower position recognizing mechanism 34 includes a lower camera 36 provided with an image pick-up device 36a and set in a position with the image pick-up device 36a facing up. An upper position recognizing mechanism 33 is disposed at a level higher than that of the second holding member 46. The upper position recognizing mechanism 33 takes an image of the carrying member 2 held by the second holding member 46 to obtain position information about the position of the carrying member 2. The upper position recognizing mechanism 33 includes an upper cameral 35 provided with an image pick-up device 35a and set in a position with the image pick-up device 35a facing down, and a scanning mechanism for moving the upper camera 35 along the Y-axis for scanning.

The liquid crystal wax pouring mechanism 32 includes a dispenser 59 for pouring the liquid crystal wax onto the carrying member 2 being carried, a liquid crystal wax source 60 for supplying the liquid crystal wax to the dispenser 59, and a driving mechanism 61 for driving the dispenser 59 for movement in horizontal directions. A heating device, not shown, heats the liquid crystal wax being supplied from the liquid crystal wax source 60 to the dispenser 59 to liquefy the liquid crystal wax. Thus dispenser 59 pours the liquid-phase liquid crystal wax onto the carrying member 2.

The melted liquid crystal wax for pasting together the thin plate 1 and the carrying member 2 has a crystalline characteristic. The liquid crystal wax changes suddenly from a liquid phase to a solid phase and vice versa at a specific temperature. Possible liquid crystal waxes are those containing an organic carboxylic acid derivative containing long-chain alkyl groups as a principal component, those containing an alcohol as a principal component and those containing an ester as a principal component.

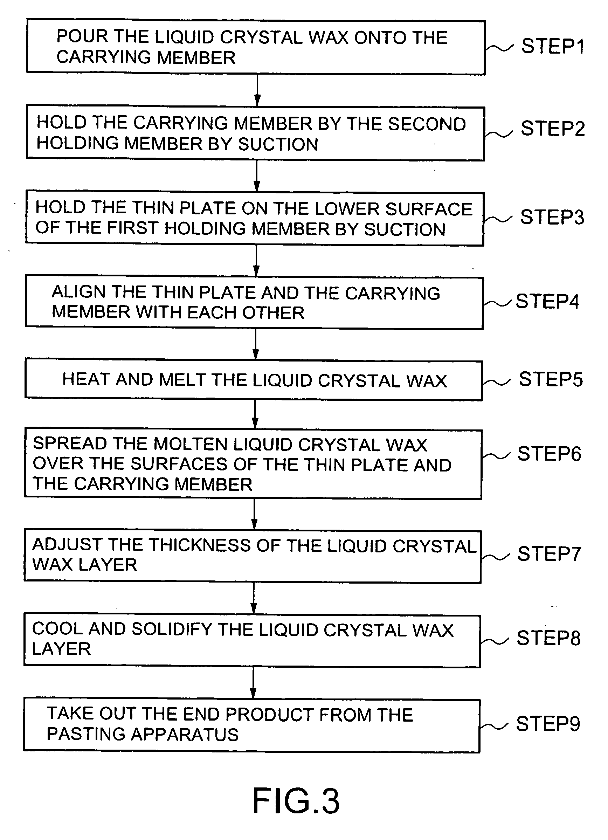

A pasting method of pasting together the thin plate 1 and the carrying member 2 to be carried out by the foregoing pasting apparatus 40 will be described in connection with a flow chart shown in Fig. 3.

The robot arm 23 of the carrying robot 22 takes out the carrying member 2 from the carrying member cassette 12 placed in the loading and unloading unit 10. In STEP 1, the liquid crystal wax pouring mechanism 32 pours the liquid crystal wax 4 onto the carrying member 2 while the carrying member 2 is being carried by the carrying robot 22. The main controller 40a controls the liquid crystal wax pouring mechanism 32 so as to pour a predetermined, necessary amount of the liquid crystal wax 4 onto the carrying member 2. In STEP 2, the carrying member 2 thus provided with the liquid crystal wax 4 is carried onto the second holding member 46 of the pasting apparatus 40 and the second holding member 46 holds the carrying member 2 thereon by suction.

In STEP 3, the thin plate 1 is taken out from the thin plate cassette 11 placed in the loading and unloading unit 10, the head [plate 41 is opened, the thin plate 1 is carried to a position corresponding to the first holding member 44 of the pasting apparatus 40, the head plate 41 is closed, and the thin plate is held on the lower surface of the first holding member 44 fixed to the head plate 41 by suction.

Then, in STEP 4, the upper camera 35 of the upper position recognizing mechanism 33 and the lower camera 36 of the lower position recognizing mechanism 34 measure the respective positions of the joining surface of the carrying member 2 and the thin plate 1, respectively, and the thin plate 1 and the carrying member 2 are aligned with each other on the basis of position data obtained by the upper camera 35 and the lower camera 36. More specifically, the XYZθ moving mechanism 45 adjusts the alignment of the thin plate 1 and the carrying member 2 in a plane, and the piezoelectric mechanism 52 adjusts the parallelism between the thin plate 1 and the carrying member 2.

In STEP 5, the XYZθ moving mechanism 45 raises the second holding member 46 near to the thin plate 1 to place the carrying member 2 at a predetermined distance from the thin plate 1, the heater 49 heats the second holding member 46 to melt the liquid crystal wax 4. In STEP 6, the carrying member 2 is turned with the molten liquid crystal wax 4 held between the thin plate 1 and the carrying member 2 by a combined effect of motions in directions parallel to the X-axis and motions in directions parallel to the Y-axis of the XYZθ moving mechanism 45 to spread the liquid crystal wax 4 over the entire surfaces of the thin plate 1 and the carrying member 2.

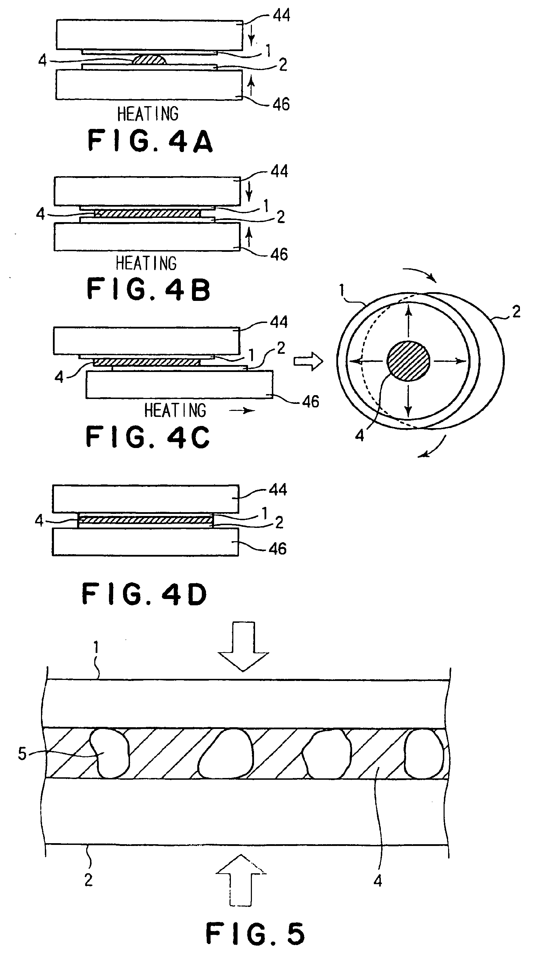

This operation will be explained with reference to Figs. 4A to 4D. As shown in Fig. 4A, the liquid crystal wax 4 held between the thin plate 1 and the carrying member 2 is heated, the second holding member 46 is raised to compress the liquid crystal wax 4 to spread the liquid crystal wax 4 to some extent as shown in Fig. 4B. Then, as shown in Fig. 4C, the XYZθ moving mechanism 45 moves the second holding member 46 simultaneously in directions parallel to the X- and the Y-direction to revolve the carrying member 2 relative to the thin plate 1. Part of the liquid crystal wax 4 is forced out of the surface of the carrying member 2 when the liquid crystal wax 4 is thus spread. However, the surface tension of the liquid crystal wax 4 retains the part of the liquid crystal wax 4 forced out of the surface of the carrying member 2. Consequently, the predetermined, necessary amount of the liquid crystal wax 4 is spread over the entire surfaces of the thin plate 1 and the carrying member 2 without producing any bubbles in the liquid crystal wax 4. Thus the liquid crystal wax 4 can be spread in the entire space between the thin plate 1 and the carrying member 2 as shown in Fig. 4D.

In STEP 7, the carrying member 2 is aligned with the thin plate 1 on the basis of measured data on the positions of the thin plate 1 and the carrying member 2 in a state where the carrying member 2 is aligned with the thin plate 1 in a plane, and the thickness of the liquid crystal wax 4 is adjusted to a predetermined thickness. Operations for aligning the carrying member 2 with the thin plate 1 and for adjusting the thickness of the liquid crystal wax 4 can be easily carried out because the liquid crystal wax is not solidified yet.

The adjustment of the thickness of the liquid crystal wax 4 can be achieved by moving the second holding member 46 in a direction parallel to the Z-axis so as to adjust the gap between the thin plate 1 and the carrying member 2, provided that motions of the XYZθ moving mechanism in directions parallel to the Z-axis is sufficiently accurate. This thickness adjusting operation is effective when any three-dimensional pattern is not formed on the thin plate 1.

If any three-dimensional pattern is not formed on the thin plate 1, the thickness of the liquid crystal wax 4 can be adjusted to a desired thickness by adding particles of a fixed particle size corresponding to the desired thickness in the liquid crystal wax 4 and raising the second holding member 46 as far as the particles are held between the thin plate 1 and the carrying member 2 as shown in Fig. 5. When the particles are held between the thin plate 1 and the carrying member 2, a pressure applied to the liquid crystal wax 4 increases sharply. Therefore, the completion of thickness adjustment can be realized by detecting the sharp increase in the pressure applied to the liquid crystal wax 4. A preferable thickness of the liquid crystal wax 4 when any three-dimensional pattern is not formed on the thin plate 1 is between about 5 and about 10 µm.

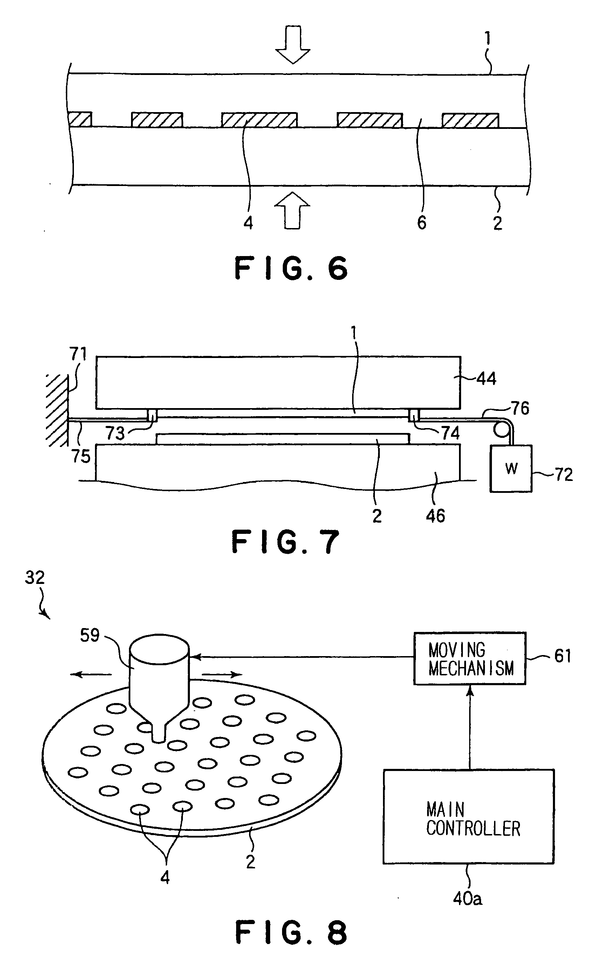

If a three-dimensional pattern 6 is formed on the thin plate 1, the liquid crystal wax 4 is formed in a thickness corresponding to the height of the three-dimensional pattern 6 by raising the second holding member 46 until the carrying member 2 comes into contact with the lower end of the three-dimensional pattern 6. Reaction force acting on the second holding member 46 increases sharply after the carrying member 2 has come into contact with the lower end of the three-dimensional pattern 6 as shown in Fig. 6. Therefore, the completion of thickness adjustment can be realized by detecting the sharp increase in the reaction force.

After the thickness of the liquid crystal wax 4 has been thus adjusted, the liquid crystal wax 4 is heated for a predetermined time. Then, in STEP 8, a cooling medium, such as cooling water, is passed through the coolant passage 51 of the second holding member 46 to cool the liquid crystal wax 4 through the second holding member 46 and the carrying member 2 at a predetermined cooling rate to solidify the liquid crystal wax 4. The liquid crystal wax 4 melts when heated at a temperature of 200°C or above and solidifies at a temperature between 150°C and 200°C. Preferably, the cooling rate is 10°C/min.

After an end product formed by thus pasting together the thin plate 1 and the carrying member 2 has been cooled to a predetermined temperature, the suction of the first holding member 44 is removed to hold the end product by the second holding member 46. Subsequently, the suction of the second holding member 46 is removed. Then in STEP 9, the robot arm 23 of the carrying robot 22 holds the end product and carries the same to the end product cassette 13 placed in the loading and unloading unit 10.

When the liquid crystal wax is used for pasting together the thin plate 1 and the carrying member 2, the thin plate 1 and the carrying member 2 can be pasted together and can be separated in a very short time and the thin plate 1 will not be displaced relative to the carrying member 2 because the liquid crystal wax changes suddenly from a solid phase to a liquid phase and vice versa at a specific temperature.

The thin plate 1 and the carrying member 2 can be held vertically opposite to each other by suction with their joining surface extended in high flatness. The XYZθ moving mechanism 45 can move carrying member 2 in directions parallel to the X, the Y- and the Z-axis and turns the carrying member in the θ-direction relative to the thin plate 1. The upper position recognizing mechanism 33 and the lower position recognizing mechanism 34 measure the respective positions of the carrying member 2 and the thin plate 1, respectively, and the thin plate 1 and the carrying member 2 are aligned in a plane on the basis of position information provided by the upper position recognizing mechanism 33 and the lower position recognizing mechanism 34. The piezoelectric mechanism 52 adjusts the parallelism between the thin plate 1 and the carrying member 2. Consequently, the thin plate 1 can be accurately pasted to the carrying member 2 in satisfactory flatness. The liquid-phase liquid crystal wax 4 held between the thin plate 1 and the carrying member 2 is spread over the entire surfaces of the thin plate 1 and the carrying member 2 by moving the thin plate 1 and the carrying member 2 relative to each other. Consequently, the liquid crystal wax 4 not containing any bubbles can be spread in a uniform thickness over the surfaces of the thin plate 1 and the carrying member 2 and thereby the thin plate 1 can be surely pasted to the carrying member 2. When the liquid crystal wax is thus spread, the surface tension of the liquid crystal wax prevents the liquid crystal wax from falling off the space between the thin plate 1 and the carrying member 2.

When the thin plate 1 is very thin and is a metal foil, such as a copper foil, of a thickness of 100 µm or below, the thin plate 1 is liable to warp and it is likely that the thin plate 1 cannot be held in a desired flatness only by suction. In such a case, it is preferable to hold the thin plate 1 with a tensile force applied thereto on the first holding member 44 by placing wire connectors 73 and 74 at opposite sides of the thin plate 1, connecting wires 75 and 76 respectively to the wire connectors 73 and 74, connecting the wire 75 to a fixed wall 71 and connecting the other wire 75 to a weight 72 as shown in Fig. 7 instead of using suction or using suction in combination with the tensile force for holding the thin plate on the first holding member 44. The thin plate 1 can be forcibly flattened out by thus applying the tensile force to the thin plate 1 and the thin plate 1 can be extended in a desired flatness even if the thin plate 1 is very thin.

The foregoing pasting work is carried out under heat. Therefore, if the difference between the respective coefficients of thermal expansion of the thin plate 1 and the carrying member is large, it is likely that the thin plate 1 pasted to the carrying member 2 separates from the carrying member 2 during the cooling process due to the difference in coefficient of thermal expansion between the thin plate 1 and the carrying member 2. For example, copper has a coefficient of thermal expansion of 16.78×10⁻⁶, silicon has a coefficient of thermal expansion of 3.63×10⁻⁶ and a low thermal expansion glass has a coefficient of thermal expansion in the range of 3× to 3.5×10⁻⁶. If the thin plate 1 is a metal foil and the carrying member 2 is a silicon wafer or a substrate of a low thermal expansion glass, it is likely that the thin plate 1 separates from the carrying member 2 during the cooling process.

Therefore, if the thin plate 1 is a silicon wafer, it is preferable that the carrying member 2 is an object made of a material having a coefficient of thermal expansion substantially equal to that of the thin plate 1, such as a silicon wafer or a substrate made of a low thermal expansion glass. If the thin plate 1 is metal plate having a large coefficient of thermal expansion, such as a copper foil, it is preferable that the carrying member 2 is an object made of a metal. The carrying member 2 may be made of a stainless steel of the quality SUS316L specified in JIS. It is preferable that the carrying member made of a metal is processed by a straightening process.

It is preferable to form grooves or dimples in the joining surface of the carrying member 2 to further surely prevent the liquid crystal wax from being forced out of the joining surface of the carrying member and from containing bubbles.

When a three-dimensional pattern is formed on the thin plate 1, the liquid crystal wax 4 cannot be spread over the entire surfaces of the thin plate 1 and the carrying member 2 and voids are likely to be formed in a liquid crystal wax film formed by spreading the liquid crystal wax 4 if the liquid crystal wax 4 is poured onto a single part of the joining surface of the carrying member 2 as shown in Fig. 4A because the three-dimensional pattern obstructs the spread of the liquid crystal wax 4. When a three-dimensional pattern is formed on the thin plate 1, it is preferable that pattern data on the pattern is entered previously into the main controller 40a, the main controller 40a control the driving mechanism 61 of the liquid crystal wax pouring mechanism 32 according to the pattern data to move the dispenser 59 so that the liquid crystal wax 4 is poured onto parts of the carrying member 2 corresponding to recesses in the three-dimensional pattern. When the liquid crystal wax 4 is thus poured onto the parts corresponding to the recesses in the three-dimensional pattern voids will be scarcely formed in a liquid crystal wax film formed by spreading the liquid crystal wax 4.

Although the pasting method and the pasting apparatus 40 have been described as applied to pasting the thin plate 1 and the carrying member 2 together, the pasting method and the pasting apparatus 40 do not need necessarily to be applied to pasting the thin plate 1 and the carrying member 2 together, and may be applied to pasting two functional members together. For example, the pasting method and the pasting apparatus 40 can be applied to pasting two silicon wafers, namely, functional members, together and to pasting two metal foils. The member to which the functional member is to be pasted may be a thick member. In the foregoing description only the lower second holding member 46 is moved by the XYZθ moving mechanism 45, only the upper first holding member 44 may be moved or both the first holding member 44 and the second holding member 46 may be moved. In the foregoing description, the liquid crystal wax 4 is poured onto the carrying member 2 held on the robot arm 23 before loading the carrying member 2 into the main unit 31. The time for pouring the liquid crystal wax 4 onto the carrying member 2 is not limited to that and may be poured at any suitable time. The thin plate 1 and the carrying member 2 may be replaced with each other to place the thin plate 1 under the carrying member 2 and the liquid crystal wax 4 may be poured onto the thin plate 1.

A pasting apparatus 80 in a second embodiment according to the present invention will be described.

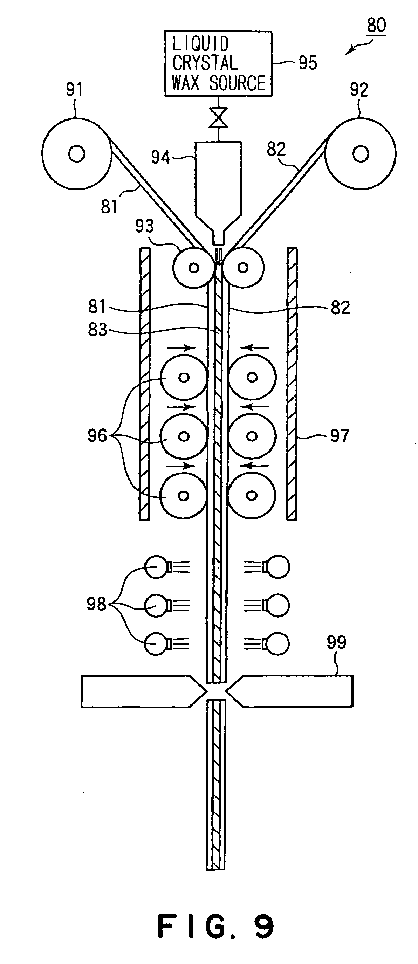

Referring to Fig. 9 showing the pasting apparatus 80 in the second embodiment in a sectional view, the pasting apparatus 80 pastes together a metal foil 81, such as a copper foil, and a metal carrying member 82 made of a metal, such as a stainless steel. A first roll 91 for supplying the metal foil 81 and a second roll 92 for supplying the metal carrying member 82 are disposed parallel to each other. The metal foil 81 supplied from the first roll 91 and the metal carrying member 82 supplied from the second roll 92 are guided obliquely downward so as to approach each other.

The metal foil 81 and the metal carrying member 82 are guided by guide rollers 93 so as to run downward with a space formed between the metal foil 81 and the metal carrying member 82. A dispenser 94 is disposed above the guide rollers 93 to pour a liquid crystal wax into the space between the metal foil 81 and the metal carrying member 82. A liquid crystal wax source 95 supplies the liquid crystal wax to the dispenser 94. The liquid crystal wax is heated and melted by a heating device, not shown, to make the liquid crystal wax flow smoothly.

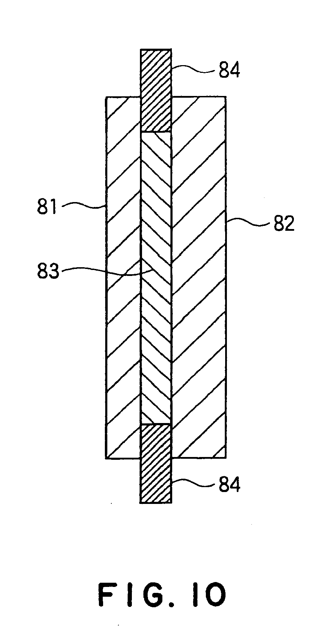

Each of spacers 84 is interposed between opposite side edge parts of the metal foil 81 and the metal carrying member 82 running downward as shown in a sectional view taken in a horizontal plane in Fig. 10. The spacers 84 are sent into spaces between the opposite side edge parts of the metal foil 81 and the metal carrying member 82 from rolls, not shown. The spacers 84 are taken up on take-up rollers, not shown, disposed at the lower end of the pasting apparatus 80. The spacers 84 determines the thickness of a liquid crystal wax film 83 to be formed between the metal foil 81 and the metal carrying member 82 and the width of a laminated structure formed by pasting together the metal foil 81 and the metal carrying member 821

A plurality of pairs of pressure rollers 96, three pairs of pressure rollers 96 in this embodiment, are arranged vertically below the guide rollers 93 along the metal foil 81 and the metal carrying member 82. The pressure rollers 96 compresses the liquid crystal wax film 83 formed between the metal foil 81 and the metal carrying member 82 to adjust the thickness of the liquid crystal wax film 83 to a value equal to the thickness of the spacers 84.

A heater 97 surrounds the guide rollers 93 and the pressure rollers 96 to heat the liquid crystal wax film 83 to keep the liquid crystal wax film 83 in a molten state.

A plurality of pairs of cooling nozzles 98, three pairs of cooling nozzles 98 in this embodiment, are arranged vertically below the pressure rollers 96. The cooling nozzles 98 blow a cooling gas to cool the molten liquid crystal wax film 83 after the molten liquid crystal wax film 83 has been formed in a desired thickness by compressing a layered structure of the metal foil 81, the metal carrying member 82 and the molten liquid crystal wax film 83 by the pressure rollers 96.

A cutter 99 is disposed below the cooling nozzles 98 to cut a laminated structure formed by solidifying the liquid crystal wax film 83 to paste the metal foil 81 and the metal carrying member 82 together. The laminated structure is cut into laminated pieces of a predetermined length.

The pasting apparatus supplies the metal foil 81 and the metal carrying member 82 individually and continuously, guides the metal foil 81 and the metal carrying member 82 downward by the guide rollers 93 keeping the space of the predetermined thickness between the metal foil 81 and the metal carrying member 82 by the spacers 84, pours the liquid crystal wax into the space between the metal foil 81 and the metal carrying member 82 to form the molten liquid crystal wax film 83, and compresses the layered structure of the metal foil 81, the metal carrying member 82 and the molten liquid crystal wax film 83 by the pressure rollers 96 while the layered structure runs downward. Therefore, even if the molten liquid crystal wax contains bubbles, the bubbles are forced to rise upward and removed from the liquid crystal wax film 83. The molten liquid crystal wax poured into the space between the metal foil 81 and the metal carrying member 82 and flowing down by its own weight can satisfactorily fill up the space. Consequently, the metal foil 81 and the metal carrying member 82 can be pasted together by the liquid crystal wax film 83 not containing any bubbles. The metal foil 81 and the metal carrying member 82 can be accurately pasted together by accurately forming the spacers 84 in a desired thickness and accurately arranging the guide rolls 91 and 92, the guide rollers 93 and the pressure rollers 96. The metal foil 81 and the metal carrying member 82 can be continuously and efficiently pasted together.

Objects to be pasted together are not limited to the metal foil and the metal carrying member; both the objects may be metal thin plates, such as metal foils.

Although the invention has been described in its preferred embodiments with a certain degree of particularities, obviously many changes and variations are possible therein. It is therefore to be understood that the present invention may be practiced otherwise than as specifically described herein without departing from the scope and spirit thereof.

## Claims

1. A pasting method of pasting a thin plate to a planar member, said pasting method comprising the steps of:
holding the thin plate and the planar member vertically opposite to each other with their joining surfaces extended in high flatness respectively on first and second holding members capable of moving in directions along an X-axis, a Y-axis and a Z-axis and of turning in a θ-direction relative to each other;
pouring a liquid crystal wax onto the thin plate when the thin plate is disposed below the planar member or onto the planar member when the planar member is disposed below the thin plate;
heating the liquid crystal wax to keep the liquid crystal wax in a liquid phase;
spreading the liquid-phase liquid crystal wax in a liquid-phase liquid crystal wax layer over the surfaces of the thin plate and the planar member by holding the liquid-phase liquid crystal wax layer between the thin plate and the planar member and moving the thin plate and the planar member relative to each other;
adjusting the thickness of the liquid-phase liquid crystal wax layer to a predetermined thickness; and
cooling the liquid-phase liquid crystal wax layer to solidify the liquid crystal wax layer.

2. A pasting method of pasting a thin plate to a planar member, said pasting method comprising the steps of:
holding the thin plate and the planar member vertically opposite to each other with their joining surfaces extended in high flatness respectively on first and second holding members capable of moving in directions along an X-axis, a Y-axis and a Z-axis and of turning in a θ-direction relative to each other;
pouring a liquid crystal wax onto the thin plate when the thin plate is disposed below the planar member or onto the planar member when the planar member is disposed below the thin plate;
aligning the thin plate and the planar member with each other on the basis of respective recognized positions of the thin plate and the planar member;
heating the liquid crystal wax to keep the liquid crystal wax in a liquid phase;
spreading the liquid-phase liquid crystal wax in a liquid-phase liquid crystal wax layer over the surfaces of the thin plate and the planar member by holding the liquid-phase liquid crystal wax layer between the thin plate and the planar member and moving the thin plate and the planar member relative to each other;
adjusting the thickness of the liquid-phase liquid crystal wax layer to a predetermined thickness; and
cooling the liquid-phase liquid crystal wax layer to solidify the liquid crystal wax layer.

3. The pasting method according to claim 2, wherein the step of aligning the thin plate and the planar member with each other adjusts the positional relation between the thin plate and the planar member in a plane and parallelism between the thin plate and the planar member.

4. The pasting method according to claim 3, wherein parallelism between the thin plate and the planar member is adjusted by using piezoelectric elements.

5. The pasting method according to any one of claims 2 to 4, wherein the step of aligning the thin plate and the planar member with each other forms respective images of the thin plate held by the first holding member and the planar member held by the second holding member, recognizes the respective positions of the thin plate and the planar member on the basis of the images, and aligns the thin plate and the planar member with each other on the basis of information about the recognized positions of the thin plate and the planar member.

6. The pasting method according to any one of claims 1 to 5, wherein the first holding member holds the thin plate by suction.

7. The pasting method according to any one of claims 1 to 6, wherein the first holding member holds the thin plate with a tensile stress induced in the thin plate in a plane containing the thin plate.

8. The pasting method according to any one of claims 1 to 7, wherein the second holding member holds the planar member by suction.

9. The pasting method according to any one of claims 1 to 8, wherein the thickness of the liquid crystal wax layer formed between the thin plate and the planar member is adjusted by adjusting the thickness of the space between the thin plate and the planar member.

10. The pasting method according to any one of claims 1 to 8, wherein the thickness of the liquid crystal wax layer formed between the thin plate and the planar member is adjusted to the diameter of particles by mixing the particles in the liquid crystal wax forming the liquid crystal wax layer and moving the first and the second holding member so as to hold the particles between the thin plate and the planar member.

11. The pasting method according to any one of claims 1 to 8, wherein, when a three-dimensional pattern is formed on the thin plate, the thickness of the liquid crystal wax layer formed between the thin plate and the planar member is adjusted to the thickness of the three-dimensional pattern by moving the first and the second holding member so as to bring the free surface of the three-dimensional pattern into contact with the planar member.

12. The pasting method according to any one of claims 1 to 11, wherein materials respectively forming the thin plate and the planar member have nearly equal coefficients of thermal expansion, respectively.

13. The pasting method according to claim 12, wherein the thin plate is a silicon wafer, and the planar member is a silicon wafer or a glass substrate.

14. The pasting method according to claim 12, wherein the thin plate is a metal foil and the planar member is a metal plate.

15. A pasting apparatus for pasting a thin plate to a planar member, said pasting apparatus comprising:
first and second holding members respectively for holding the thin plate and the planar member opposite to each other so that respective joining surfaces of the thin plate and the planar member face each other;
first and second holding mechanisms respectively for operating the first and the second holding member to hold the thin plate and the planar member flat respectively on the first and the second holding member;
a moving mechanism for moving the first and the second holding member relative to each other in directions along an X-axis, a Y-axis and a Z-axis and turning the same in a θ-direction;
a liquid crystal wax pouring mechanism for pouring a liquid crystal wax onto the thin plate when the thin plate is disposed below the planar member or onto the planar member when the planar member is disposed below the thin plate;
heating means incorporated into at least either of the first and the second holding member;
cooling means incorporated into at least either of the first and the second holding member; and
a control mechanism for spreading the liquid crystal wax liquefied by the heating means in a liquid-phase liquid crystal wax layer over the joining surfaces of the thin plate and the planar member by holding the liquid-phase liquid crystal wax layer between the thin plate and the planar member and moving the thin plate and the planar member relative to each other.

16. The pasting apparatus according to claim 15, wherein the thickness of the liquid crystal wax layer is adjusted through the adjustment of the thickness of the space between the thin plate and the planar member by moving the first and the second holding member relative to each other by the moving mechanism.

17. A pasting apparatus for pasting a thin plate to a planar member, said pasting apparatus comprising:
first and second holding members respectively for holding the thin plate and the planar member opposite to each other with the respective joining surfaces of thereof facing each other;
first and second holding mechanisms respectively for making the first and the second holding member hold the thin plate and the planar member flat, respectively;
a moving mechanism for moving the first and the second holding member relative to each other in directions along an X-axis, a Y-axis, a Z-axis and turning the same in a θ-direction;
a position recognizing mechanism for recognizing the respective positions of the thin plate and the planar member;
a parallelism adjusting mechanism for adjusting parallelism between the thin plate and the planar member;
a liquid crystal wax pouring mechanism for pouring a liquid crystal wax onto the thin plate when the thin plate is disposed below the planar member or onto the planar member when the planar member is disposed below the thin plate;
heating means incorporated into at least either of the first and the second holding member;
cooling means incorporated into at least either of the first and the second holding member; and
a control means for controlling the parallelism adjusting mechanism and the moving mechanism;
wherein the control means controls the parallelism adjusting mechanism and the moving mechanism on the basis of information provided by the position recognizing mechanism to position the thin plate and the planar member in a predetermined positional relation, and controls the moving mechanism in a state where the liquid crystal wax is held between the thin plate and the planar member to move the thin plate and the planar member relative to each other to spread the liquid crystal wax in a liquid crystal wax layer over the surfaces of the thin plate and the planar member.

18. The pasting apparatus according to claim 17, wherein the control means controls an operation of the moving mechanism for moving the thin plate and the planar member relative to each other in a direction along the Z-axis to adjust the thickness of the space between the thin plate and the planar member.

19. The pasting apparatus according to claim 17 or claim 18, wherein the parallelism adjusting mechanism includes piezoelectric elements.

20. The pasting apparatus according to any one of claims 17 to 19, wherein the position recognizing mechanism includes a first camera for forming an image of the thin plate held by the first holding member, and a second camera for forming an image of the planar member held by the second holding member; and recognizes the respective positions of the thin plate and the planar member on the basis of the images formed by the first and the second camera.

21. The pasting apparatus according to any one of claims 15 to 20, wherein the first holding member holds the thin plate by suction.

22. The pasting apparatus according to any one of claims 15 to 21, wherein the first holding member holds the thin plate with a tensile stress induced in the thin plate in a plane containing the thin plate.

23. The pasting apparatus according to any one of claims 15 to 22, wherein the second holding member holds the planar member by suction.

24. A pasting method of pasting together two thin metal plates, said pasting method comprising the steps of:
individually and continuously supplying the two thin metal plates;
guiding the two thin metal plates downward with the two thin metal plates spaced from each other by a space of a predetermined thickness;
pouring down a liquid crystal wax into the space between the two thin metal plates;
pressing the two thin metal plates holding the liquid crystal wax and moving downward to paste the two thin metal plates together;
solidifying the liquid crystal wax by cooling the liquid crystal wax held between the two thin metal plates after the two thin metal plates have been pasted together in a laminated structure; and
cutting the laminated structure.

25. A pasting apparatus for pasting together two thin metal plates, said pasting apparatus comprising:
two supply rolls for individually and continuously supplying the two thin metal plates;
guide rollers for guiding the two thin metal plates downward with the two thin metal plates spaced from each other by a space of a predetermined thickness;
a liquid-phase liquid crystal wax pouring mechanism for pouring down a liquid-phase liquid crystal wax into the space between the two thin metal plates;
pressure rollers for pressing the two thin metal plates to paste together the two thin metal plates holding the liquid crystal wax and moving downward;
heating means for heating the two thin metal plates being pressed between the pressure rollers;
cooling means for cooling the liquid crystal wax held between the two thin metal plates after the two thin metal plates have been pasted together in a laminated structure to solidify the liquid crystal wax; and
cutting means for cutting the laminated structure.
